# EUROPÄISCHE PATENTSCHRIFT

(11) **EP 2 977 149 B1**
(45) Veröffentlichungstag und Bekanntmachung des Hinweises auf die Patenterteilung: **17.03.2021**
(21) Anmeldenummer: 15002174.9
(22) Anmeldetag: 22.07.2015
(51) Int. Cl.: B25J 9/16

(54) **VERFAHREN UND MITTEL ZUM AUSLEGEN UND/ODER BETREIBEN EINES ROBOTERS**
METHOD AND MEANS FOR DESIGNING AND/OR OPERATING A ROBOT
PROCEDE ET MOYEN DE CONCEPTION ET/OU DE FONCTIONNEMENT D'UN ROBOT

(30) Priorität: 24.07.2014 DE 102014011012
(43) Veröffentlichungstag der Anmeldung: 27.01.2016
(73) Patentinhaber: KUKA Deutschland GmbH, 86165 Augsburg (DE)
(72) Erfinder: Walther, Steffen, 80687 München (DE)
(74) Vertreter: Schlotter, Alexander Carolus Paul

(56) Entgegenhaltungen:
- WO-A1-2014/102018
- DE-A1-102010 063 208
- JP-A- 2013 082 071
- HADDADIN S ET AL: "On making robots understand safety: Embedding injury knowledge into control", INTERNATIONAL JOURNAL OF ROBOTICS RESEARCH, SAGE SCIENCE PRESS, THOUSAND OAKS, US, vol. 31, no. 13, 1 October 2012 (2012-10-01), pages 1578-1602, XP002718566, ISSN: 0278-3649, DOI: 10.1177/0278364912462256

## Beschreibung

Die vorliegende Erfindung betrifft ein Verfahren und Mittel zum Auslegen und/oder Betreiben eines Roboters sowie ein Computerprogrammprodukt zur Durchführung eines solchen Verfahrens.

Wenn Menschen sich im Wirkungsbereich eines Roboters aufhalten, insbesondere mit dem Roboter kooperieren sollen, kann es durch eine Kollision des Roboters zu Kontakten des Menschen mit dem Roboter und/oder der Umgebung kommen.

Aus der DE 10 2013 212 887 A1 ist daher ein Verfahren zum Steuern einer Robotereinrichtung bekannt, bei dem eine Bewegung eines robotergeführten Endeffektors unter Berücksichtigung medizinischer Verletzungsparameter überwacht und angepasst wird. Hierzu werden für verschiedene relevante Punkte ("points of interest" POIs) jeweils zulässige maximale Geschwindigkeiten bestimmt. Dann wird die konservativste Geschwindigkeitsbegrenzung unter allen Punkten ausgewählt und die Bewegung des Roboters auf deren Einhaltung hin überwacht und angepasst.

Die WO 2014/102018 A1 betrifft ein Verfahren zur Reduzierung einer potentiellen Verletzung eines Werkers durch ein robotergeführtes Werkstück basierend auf verschiedenen Werten für eine Relativgeschwindigkeit zwischen Werker und Werkstück, Trägheit des bewegten Teiles des Roboters, Verletzbarkeit des Körperteils des Werkers und Gefährlichkeit des Werkstücks, wobei ein Grad einer potentiellen Verletzung vorausgesagt wird.

Aufgabe der vorliegenden Erfindung ist es, das Auslegen und/oder Betreiben eines Roboters zu verbessern.

Diese Aufgabe wird durch ein Verfahren mit den Merkmalen des Anspruchs 1 gelöst. Anspruch 13 stellt ein entsprechendes Mittel, Anspruch 14 ein entsprechendes Computerprogrammprodukt zur Durchführung eines hier beschriebenen Verfahrens unter Schutz. Die Unteransprüche betreffen vorteilhafte Weiterbildungen.

Nach einem Aspekt der vorliegenden Erfindung werden, insbesondere teilweise oder vollständig automatisiert, durch ein hierzu hard- und/oder softwaretechnisch eingerichtetes Mittel oder durch Abarbeiten eines auf einem von einem Computer lesbaren Medium gespeicherten Programmcodes eines Computerprogrammprodukts, zum Auslegen und/oder Betreiben eines Roboters mehrere potentielle Kontakte bestimmt und für diese Kontakte jeweils eine kontaktspezifische Größe in Abhängigkeit von einem potentiellen medizinischen Schaden eines Menschen durch diesen Kontakt ermittelt.

Der Roboter weist in einer Ausführung wenigstens drei, insbesondere wenigstens sechs, insbesondere wenigstens sieben Freiheitsgrade bzw. Gelenke und/oder eine Steuerung auf, die ein erfindungsgemäßes Mittel zum Auslegen und/oder Betreiben des Roboters umfassen kann. In einer Ausführung weist der Roboter einen Endeffektor bzw. ein Werkzeug wie beispielsweise einen Greifer, eine Schweißzange oder dergleichen auf, der bzw. das zur kompakteren Darstellung vorliegend ein Teil des Roboters im Sinne der vorliegenden Erfindung sein kann. In einer anderen Ausführung besteht der Roboter hingegen nur aus mehreren dauerhaft gelenkig miteinander verbundenen Gliedern und Antrieben zum Aktuieren der Glieder, die eine mobile oder umgebungsfeste Basis mit einem End- bzw. Werkzeugflansch zum lösbaren Befestigen eines robotergeführten Endeffektors bzw. Werkzeugs verbinden.

Nach einem Aspekt der vorliegenden Erfindung werden die Kontakte verschiedenen Gruppen zugeordnet und für, insbesondere alle oder ausgewählte, Gruppen jeweils eine oder mehrere gruppenspezifische Größen auf Basis von kontaktspezifischen Größen von dieser Gruppe zugeordneten Kontakte ermittelt.

Durch die Zusammenfassung von Kontakten und die zusätzliche Ermittlung von gruppenspezifischen Größen können in einer Ausführung die Kontakte bzw. kontaktspezifischen Größen vorteilhafter ermittelt und/oder ausgewertet werden. So kann beispielsweise eine Gruppe identifiziert werden, deren Kontakte überdurchschnittliche kontaktspezifische Größen aufweisen, beispielsweise ein besonders hohes medizinisches Schadensrisiko oder eine besonders limitierende Geschwindigkeitsbegrenzung.

Vorstehend wurde insbesondere eine Risikobewertung der potentiellen Kontakte durch die kontaktspezifischen Größen beschrieben, die hierzu in Abhängigkeit von einem potentiellen medizinischen Schaden eines Menschen durch den jeweiligen Kontakt ermittelt werden. Die gruppenspezifischen Größen basieren dann bereist auf dieser Risikobewertung.

Gleichermaßen können auch zunächst kontaktspezifische Größen ermittelt werden, die einen potentiellen medizinischen Schaden eines Menschen durch den jeweiligen Kontakt (mit) bestimmen bzw. beeinflussen bzw. von denen ein potentieller medizinischer Schaden eines Menschen durch den jeweiligen Kontakt abhängt, beispielsweise eine Kontaktgeschwindigkeit oder eine Trägheit bzw. Masse. Dann können gruppenspezifische Größen auf Basis dieser kontaktspezifischen Größen in Abhängigkeit von einem potentiellen medizinischen Schaden eines Menschen durch den jeweiligen Kontakt ermittelt werden. Mit anderen Worten kann eine Risikobewertung auch, gegebenenfalls erst, für die gruppenspezifischen Größen durchgeführt werden.

Beispielsweise kann also für die jeweiligen Kontakte als kontaktspezifische Größen jeweils eine zur Vermeidung unzulässiger medizinischer Schäden eines Menschen maximal zulässige Geschwindigkeit ermittelt werden, d.h. bereits basierend auf einer Risikobewertung des jeweiligen Kontakts. Die gruppenspezifische Größe kann dann ihrerseits beispielsweise die jeweils kleinste maximal zulässige Geschwindigkeit einer Gruppe oder die Anzahl der Kontakte angeben, deren maximal zulässige Geschwindigkeit einen Grenzwert unterschreitet.

Gleichermaßen kann zunächst für die jeweiligen Kontakte als kontaktspezifische Größen jeweils eine Geschwindigkeit, zum Beispiel in Kontaktstoß- bzw. Normalrichtung, ermittelt werden, d.h. noch ohne Risikobewertung des jeweiligen Kontakts. Die gruppenspezifische Größe kann dann beispielsweise die Anzahl der Kontakte angeben, deren Geschwindigkeit eine zur Vermeidung unzulässiger medizinischer Schäden eines Menschen maximal zulässige Geschwindigkeit überschreitet. In diesem Fall werden somit die gruppenspezifischen Größen basierend auf einer Risikobewertung des jeweiligen Kontakts ermittelt.

Entsprechend werden nach einem Aspekt der vorliegenden Erfindung, insbesondere teilweise oder vollständig automatisiert, durch ein hierzu hard- und/oder softwaretechnisch eingerichtetes Mittel oder durch Abarbeiten eines auf einem von einem Computer lesbaren Medium gespeicherten Programmcodes eines Computerprogrammprodukts, zum Auslegen und/oder Betreiben eines Roboters mehrere potentielle Kontakte bestimmt, für diese Kontakte jeweils eine kontaktspezifische Größe ermittelt, die Kontakte verschiedenen Gruppen zugeordnet und für, insbesondere alle oder ausgewählte, Gruppen jeweils eine oder mehrere gruppenspezifische Größen auf Basis von kontaktspezifischen Größen von dieser Gruppe zugeordneten Kontakte und in Abhängigkeit von einem potentiellen medizinischen Schaden eines Menschen durch die Kontakte ermittelt, auf deren Basis die gruppenspezifische Größen ermittelt wird.

Auch durch diese Zusammenfassung von Kontakten, gegebenenfalls noch ohne Risikobewertung, und die zusätzliche Ermittlung von gruppenspezifischen Größen auf Basis einer Risikobewertung können in einer Ausführung die Kontakte bzw. kontaktspezifischen Größen vorteilhafter ermittelt und/oder ausgewertet werden. So kann beispielsweise eine Gruppe identifiziert werden, deren Kontakte überdurchschnittliche kontaktspezifische Größen aufweisen, beispielsweise besonders große Geschwindigkeiten oder reflektierte Trägheiten, und die somit ein besonders hohes Risiko darstellt und entsprechend vorranging zu behandeln ist.

In einer Ausführung sind bzw. werden, insbesondere vollständig oder teilweise automatisiert und/oder durch Benutzereingabe, Gruppen vorgegeben und Kontakte, insbesondere vollständig oder teilweise automatisiert und/oder durch Benutzereingabe, diesen vorgegebenen Gruppen zugeordnet. Beispielsweise können die Kontakte, die an einem Arm des Roboters auftreten können, einer diesen Arm repräsentierenden Gruppe zugeordnet werden. Dann kann ermittelt werden, ob der Arm ein besonders hohes medizinisches Schadensrisiko aufweist, und der Arm daraufhin gezielt anders ausgelegt und/oder betrieben, insbesondere bewegt, werden.

Zusätzlich oder alternativ sind bzw. werden, insbesondere vollständig oder teilweise automatisiert und/oder durch Benutzereingabe, Gruppen durch, insbesondere vollständig oder teilweise automatisiert und/oder durch Benutzereingabe, vorgegebene Kontakte (neu) definiert. So können beispielsweise vorgegebene Kontakte wahlweise zu verschiedenen, für das Auslegen und/oder Betreiben relevante Gruppen zusammengefasst werden, beispielsweise alternativ zu einer Gruppe durch den Roboter bewegter Kontakte und der komplementären Gruppe der unbewegten Kontakte.

In einer Ausführung werden die Kontakte wenigstens zwei verschiedenen Gruppen zugeordnet bzw. sind bzw. werden wenigstens zwei verschiedenen Gruppen vorgegeben bzw. definiert. In einer Weiterbildung entspricht oder übersteigt die Anzahl der Gruppen die Anzahl der Gelenke bzw. Freiheitsgrade des Roboters, so dass insbesondere jedem Roboterglied wenigstens eine Gruppe zuordenbar ist.

Erfindugsgemäß werden bzw. sind wenigstens einer Gruppe, vorzugsweise wenigstens zwei Gruppen, jeweils wenigstens zwei Kontakte zugeordnet. Hierdurch kann in einer Ausführung insbesondere komplexen Bewegungen Rechnung getragen werden.

In einer Ausführung werden eine oder mehrere gruppenspezifische Größen jeweils auf Basis eines Vergleichs von kontaktspezifischen Größen mit- bzw. untereinander innerhalb der Gruppe ermittelt. Insbesondere kann eine solche gruppenspezifische Größe auf Basis einer maximalen oder minimalen kontaktspezifischen Größe innerhalb der Gruppe ermittelt werden, insbesondere diese sein. Zusätzlich oder alternativ kann eine solche gruppenspezifische Größe eine relative Sortierung der kontaktspezifischen Größe innerhalb der Gruppe nach ihrer Größe und/oder eine statistische Größe der kontaktspezifischen Größe innerhalb der Gruppe umfassen, insbesondere sein, insbesondere ein Mittelwert, eine Standardabweichung oder dergleichen.

So kann in einem Beispiel die gruppenspezifische Größe jeweils die maximale kontaktspezifische Größe innerhalb der Gruppe sein, um so Gruppen mit einem besonders hohen medizinischen Schadensrisiko zu identifizieren.

Zusätzlich oder alternativ werden in einer Ausführung eine oder mehrere gruppenspezifische Größen auf Basis eines Vergleichs von kontaktspezifischen Größen mit einem oder mehreren vorgegebenen Grenzwerten innerhalb der Gruppe ermittelt. Insbesondere kann eine solche gruppenspezifische Größe eine absolute Sortierung der kontaktspezifischen Größe innerhalb der Gruppe in durch den bzw. die Grenzwerte vorgegebene Klassen umfassen, insbesondere sein.

So kann in einem Beispiel die gruppenspezifische Größe jeweils die Anzahl der kontaktspezifischen Größen innerhalb der Gruppe sein, die einen vorgegebenen Grenzwert übersteigen, um so Gruppen mit besonders vielen risikoindizierenden Kontakten zu identifizieren.

In einer Ausführung werden eine oder mehrere gruppenspezifische Größen jeweils auf Basis einer Mittelung von, insbesondere ausgewählten oder allen, kontaktspezifischen Größen innerhalb der Gruppe ermittelt. Auf diese Weise können zum Beispiel Gruppen mit vielen Kontakten durch eine einzige gruppenspezifische Größe repräsentiert werden.

In einer Ausführung werden eine oder mehrere gruppenspezifische Größen miteinander verglichen. Insbesondere können so eine maximale oder minimale gruppenspezifische Größe innerhalb der Gruppen ermittelt und/oder die Gruppen relativ zueinander auf Basis ihrer gruppenspezifischen Größen sortiert werden.

Zusätzlich oder alternativ werden in einer Ausführung eine oder mehrere gruppenspezifische Größen mit einem oder mehreren vorgegebenen Grenzwerten verglichen. Insbesondere können so die Gruppen absolut bzw. in durch die Grenzwerte vorgegebene Klassen sortiert werden

Insbesondere in vorstehend beschriebener Weise können somit potentielle Kontakte innerhalb einer Gruppe besser analysiert werden. So kann beispielsweise für eine Gruppe, die einen Arm des Roboters repräsentiert, ermittelt werden, welcher Kontakt dessen Geschwindigkeit am stärksten limitiert.

Zusätzlich oder alternativ können vorteilhaft Gruppen untereinander analysiert werden. So kann zum Beispiel ermittelt werden, welches der jeweils durch Gruppen repräsentierten Roboterglieder eine Endeffektorgeschwindigkeit des Roboters am stärksten limitiert.

In einer Ausführung werden Kontakte, insbesondere vollständig oder teilweise automatisiert, Gruppen in Abhängigkeit von ihrer Position relativ zu Strukturelementen, insbesondere Bauteilen bzw. Gliedern oder Bauteil- bzw. Gliedergruppen, des Roboters zugeordnet. So können in einem Beispiel die Kontakte einer Roboterhand und eines Endeffektors des Roboters jeweils einer eigenen Gruppe zugeordnet werden. Gleichermaßen können die Kontakte der Roboterhand und des Endeffektors auch einer gemeinsamen Gruppe zugeordnet werden, um diese beispielsweise gegenüber einer Gruppe von roboterarm- und/oder basisfesten Kontakten und/oder einer Gruppe von umgebungsfesten Kontakten zu unterscheiden und demgegenüber gemeinsam handzuhaben.

Zusätzlich oder alternativ werden Kontakte, insbesondere vollständig oder teilweise automatisiert, Gruppen in Abhängigkeit von den ihre Kinematik bestimmenden Gelenkkoordinaten des Roboters zugeordnet. So können zum Beispiel alle Kontakte, deren Geschwindigkeit (auch) von einer Bewegung einer Roboterhand abhängt, zu einer Gruppe zusammengefasst werden, deren gruppenspezifische Größe dann (auch) von der Bewegung einer Roboterhand abhängt, um so den bzw. die Kontakte zu ermitteln, die diese Bewegung am stärksten limitieren.

Wie bereits ausgeführt, werden in einer Ausführung Kontakte Gruppen vollständig oder teilweise automatisiert zugeordnet, beispielsweise aufgrund ihrer Position relativ zu Strukturelementen. Zusätzlich oder alternativ können Kontakte Gruppen auch durch Benutzereingabe wahlweise zugeordnet werden. Auf diese Weise kann der Benutzer wahlweise Gruppen zusammenstellen, um beispielsweise das maximale oder durchschnittliche medizinische Schadenspotential eines Endeffektors zu analysieren.

In einer Ausführung ist bzw. wird wenigstens ein Kontakt wenigstens zwei verschiedenen Gruppen zugeordnet. So kann beispielsweise ein Kontakt auf einem Endeffektor einerseits einer den Endeffektor repräsentierenden Gruppe und andererseits einer den gesamten Roboter repräsentierenden Gruppe zugeordnet sein bzw. werden. In einer anderen Ausführung ist bzw. wird jeder Kontakt eindeutig maximal einer Gruppe zugeordnet.

In einer Ausführung gibt wenigstens eine gruppenspezifische Größe und/oder wenigstens eine kontaktspezifische Größe jeweils einen potentiellen medizinischen Schaden eines Menschen an bzw. bewertet bzw. gewichtet diese, insbesondere gemäß einer medizinischen Klassifikation, wie beispielsweise der A0-Klassifikation. In einem sehr einfachen Beispiel kann etwa eine Größe "0" keinen Schaden, eine Größe "1" einen oberflächlichen und vorübergehenden Schaden, etwa eine Aufschürfung, eine Größe "2" einen tiefergehenden und vorübergehenden Schaden, etwa einen Knochenbruch, eine Größe "3" einen tiefergehenden und dauerhaften Schaden, etwa einen Gliedmaßen- oder Organ(funktions)verlust, und eine Größe "4" einen letalen Schaden angeben.

In einer Ausführung gibt wenigstens eine gruppenspezifische Größe und/oder wenigstens eine kontaktspezifische Größe jeweils eine, insbesondere zur Vermeidung unzulässiger medizinischer Schäden zulässige, kinematische Größe, insbesondere Geometrie, Position, Geschwindigkeit und/oder Beschleunigung, an. So kann in einem Beispiel die Größe die absolute Geschwindigkeit oder auch die maximal zulässige Geschwindigkeit zur Vermeidung unzulässiger medizinischer Schäden umfassen, insbesondere sein, wie sie in der eingangs genannten DE 10 2013 212 887 A1 beschrieben ist, auf die ergänzend Bezug genommen wird. Gleichermaßen kann in einem Beispiel die Größe die maximale Krümmung oder auch die maximal zulässige Krümmung einer Kante zur Vermeidung unzulässiger medizinischer Schäden umfassen, insbesondere sein.

Zusätzlich oder alternativ gibt in einer Ausführung wenigstens eine gruppenspezifische Größe und/oder wenigstens eine kontaktspezifische Größe jeweils eine, insbesondere zur Vermeidung unzulässiger medizinischer Schäden zulässige, dynamische Größe, insbesondere Steifigkeit und/oder Dämpfung an. So kann in einem Beispiel die Größe die reflektierte Trägheit zur Vermeidung unzulässiger medizinischer Schäden umfassen, insbesondere sein. Erfindungsgemäß gibt wenigstens eine gruppenspezifische Größe eine zur Vermeidung unzulässiger medizinischer Schäden zulässige reflektierte Trägheit an, oder umfasst eine maximal zulässige reflektierte Trägheit zur Vermeidung unzulässiger medizinischer Schäden.

Gleichermaßen kann in einem Beispiel die Größe die maximale Steifigkeit oder die maximal zulässige Steifigkeit einer Oberfläche zur Vermeidung unzulässiger medizinischer Schäden umfassen, insbesondere sein.Ein im Sinne der vorliegenden Erfindung bestimmter (potentieller) Kontakt kann insbesondere eine ein- oder mehrdimensionale Größe aufweisen, insbesondere sein, deren Parameter eine Kontaktgeometrie, insbesondere eine kontaktierbare bzw. kontaktierende Kontur, eine Oberflächenbeschaffenheit, insbesondere Rauhigkeit, Härte oder dergleichen, eine kinematische Kontaktgröße, insbesondere eine absolute oder Relativposition und/oder -orientierung, - geschwindigkeit und/oder-beschleunigung einer, insbesondere roboter- oder umgebungsfesten, Referenz, und/oder eine dynamische Kontaktgröße, insbesondere eine Kontaktsteifigkeit, -dämpfung und/oder, insbesondere reflektierte, Trägheit, beschreibt bzw. angibt. Auch diesbezüglich wird ergänzend auf die eingangs genannte DE 10 2013 212 887 A1 Bezug genommen. So kann beispielsweise ein Kontakt im Sinne der vorliegenden Erfindung ein POI umfassen, insbesondere sein, wie er in dieser DE 10 2013 212 887 A1 offenbart ist.

Entsprechend wird in einer Ausführung eine Kontaktgeometrie, eine kinematische Kontaktgröße, insbesondere eine Position, Orientierung und/oder Geschwindigkeit, und/oder eine dynamische Kontaktgröße, insbesondere eine Kontaktsteifigkeit, -dämpfung und/oder Trägheit für einen Kontakt ermittelt, wenn dieser bestimmt wird.

In einer Ausführung wird das Verfahren während des Betriebs des Roboters durchgeführt. Entsprechend wird unter einem Betreiben des Roboters insbesondere ein Steuern und/oder Überwachen des Roboters verstanden, zum Beispiel wie es die eingangs genannte DE 10 2013 212 887 A1 offenbart, auf die auch diesbezüglich ergänzend Bezug genommen wird.

So können beispielsweise statt aller kontaktspezifischen Größen im Betrieb nur gruppenspezifische Größen, etwa jeweils die maximalen kontaktspezifischen Größen innerhalb der jeweiligen Gruppe, überwacht und der Roboter derart betrieben werden, dass diese eine vorgegebene Bedingung erfüllen, beispielsweise eine zulässige Maximalgeschwindigkeit nicht überschreiten.

Zusätzlich oder alternativ wird das Verfahren vorab, insbesondere vor einer Bewegung, vorzugsweise Aktivierung, des Roboters durchgeführt. Entsprechend wird unter einem Betreiben des Roboters insbesondere auch eine (offline-)Bahnplanung verstanden, unter einem Auslegen insbesondere eine Spezifikation, Konstruktion, Veränderung und/oder eine Auswahl, beispielsweise von Modulen, Werkzeugen oder dergleichen.

So kann beispielsweise vorab das Bauteil identifiziert und gezielt konstruktiv verändert werden, dessen gruppenspezifische Größe das größte medizinische Schadenspotential anzeigt.

In einer Ausführung sind ein oder mehrere der Kontakte roboterfest. Hierdurch kann insbesondere ein potentieller Schaden eines Menschen durch eine direkte Kollision mit dem Roboter bei dessen Auslegung und/oder Betrieb berücksichtigt werden.

Zusätzlich oder alternativ sind in einer Ausführung ein oder mehrere der Kontakte umgebungsfest. Hierdurch kann insbesondere ein potentieller Schaden eines Menschen berücksichtigt werden, der durch den Roboter gegen die Umgebung gedrängt, geschoben bzw. -stoßen oder -klemmt wird, wenn der Roboter und/oder eine Zelle des Roboters, in der dieser angeordnet ist und/oder agiert, und/oder eine Applikation des Roboters ausgelegt und/oder betrieben wird. In einem einfachen Beispiel kann etwa eine Kontaktgeschwindigkeit eines umgebungsfesten Kontakts auf einer Gerade zu dem nächstgelegenen roboterfesten Kontakt liegen und dessen Geschwindigkeit gegensinnig gleich sein, da es für einen potentiellen medizinischen Schaden näherungsweise äquivalent ist, ob der Mensch beispielsweise von dem Roboter mit einer bestimmten Geschwindigkeit gegen eine Umgebungskante gedrückt wird oder der Roboter eine solche Kante gegen den Menschen drückt.

Ein Mittel im Sinne der vorliegenden Erfindung kann hard- und/oder softwaretechnisch ausgebildet sein, insbesondere eine, vorzugsweise mit einem Speicher- und/oder Bussystem daten- bzw. signalverbundene, insbesondere digitale, Verarbeitungs-, insbesondere Mikroprozessoreinheit (CPU) und/oder ein oder mehrere Programme oder Programmmodule aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus abzugeben. Ein Speichersystem kann ein oder mehrere, insbesondere verschiedene, Speichermedien, insbesondere optische, magnetische, Festkörper- und/oder andere nicht-flüchtige Medien aufweisen. Das Programm kann derart beschaffen sein, dass es die hier beschriebenen Verfahren verkörpert bzw. auszuführen imstande ist, sodass die CPU die Schritte solcher Verfahren ausführen kann und damit insbesondere den Roboter auslegen und/oder betreiben, insbesondere steuern kann.

Ein Auslegen des Roboters umfasst in einer Ausführung auch ein Auslegen einer Zelle und/oder Applikation des Roboters.

In einer Ausführung wird eine Information ausgegeben, welche eine oder mehrere Gruppen angibt, deren gruppenspezifische Größen eine Anpassung der entsprechenden Kontakte, beispielsweise eine Reduzierung ihrer reflektierten Trägheiten und/oder Steifigkeiten und/oder eine Vergrößerung einer Krümmung ihrer Kontaktgeometrie, bedingen, beispielsweise die Gruppen, deren gruppenspezifische Größe einen vorgegebenen Grenzwert übersteigt. Zusätzlich oder alternativ werden in einer Ausführung eine oder mehrere der ermittelten gruppenspezifischen Größen ausgegeben, insbesondere angezeigt, und/oder abgespeichert.

Weitere Vorteile und Merkmale ergeben sich aus den Unteransprüchen und den Ausführungsbeispielen. Hierzu zeigt, teilweise schematisiert:
- Fig. 1:: einen Roboter mit einer Steuerung zur Durchführung eines Verfahrens nach einer Ausführung der vorliegenden Erfindung; und
- Fig. 2:: den Ablauf dieses Verfahrens.

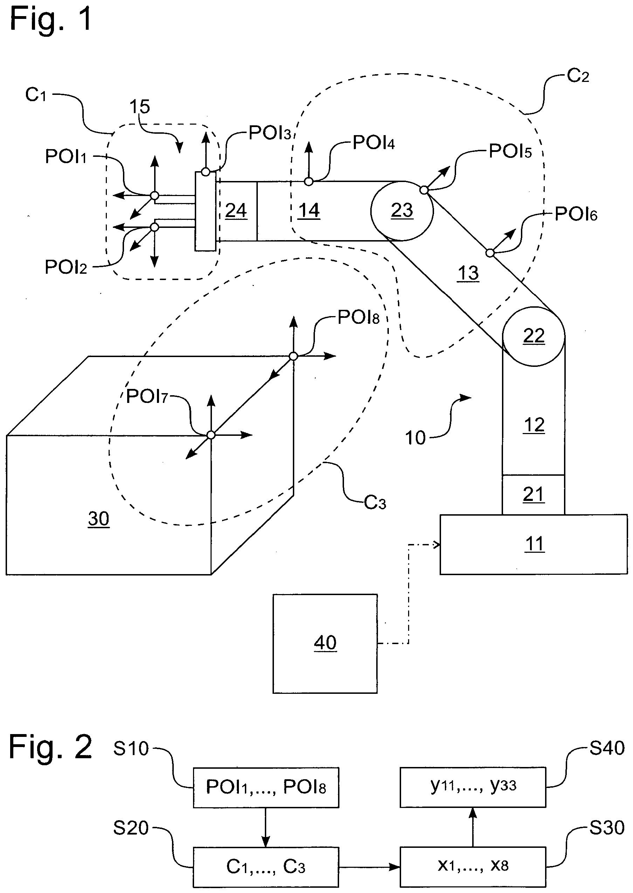

Fig. 1 zeigt einen Roboter 10 mit einer Basis 11, einem Karussell 12, einem Arm 13, einer Hand 14 und einem Werkzeug in Form eines Greifers 15, die paarweise dauerhaft miteinander gelenkig verbunden und durch Antriebe 21-24 aktuiert sind. Die Glieder 12-14 verbinden die Basis 11 mit dem Werkzeugflansch, an dem das Werkzeug 15 lösbar befestigt ist. Eine Steuerung 40 überwacht und steuert die Antriebe 21-24 und weist ein Programm zur Durchführung eines nachfolgend erläuterten Verfahrens zum Auslegen und/oder Betreiben des Roboters nach einer Ausführung der vorliegenden Erfindung auf bzw. führt dieses aus.

Nach diesem Verfahren werden zunächst in einem Schritt S10 (siehe Fig. 2) mehrere potentielle Kontakte POI₁ bis POI₈ bestimmt. Dies kann, vollständig oder teilweise, automatisiert geschehen, beispielsweise auf Basis von CAD-Daten oder dergleichen, oder auch durch Benutzereingabe.

Die roboterfesten Kontakte POI1 und POI₂ beschreiben potentielle Kontakte von Zangen des Greifers 15 mit einem Menschen und sind in Fig. 1 durch Koordinatensystem angedeutet, die potentielle Kontaktgeschwindigkeiten und -punkte beschreiben. Weiter können Parameter der Kontakte beispielsweise ihre reflektierte Trägheit, ihre Kontaktsteifigkeit und/oder -dämpfung, ihre Oberflächen- bzw. Kontakthärte und/oder-rauhigkeit und dergleichen beschreiben.

Die roboterfesten Kontakte POI₄ und POI₆ beschreiben potentielle Kontakte der Hand 14 bzw. des Arms 13 mit einem Menschen und sind in Fig. 1 durch eine Auswärtsnormalen angedeutet, die potentielle Kontaktgeschwindigkeiten und -punkte dieser als Zylinderprimitiv modellierten Roboterglieder beschreiben. Weiter können Parameter dieser Kontakte ebenfalls beispielsweise ihre reflektierte Trägheit, ihre Kontaktsteifigkeit und/oder -dämpfung, ihre Oberflächen- bzw. Kontakthärte und/oder -rauhigkeit und dergleichen beschreiben.

Die roboterfesten Kontakte POI₃ und POI₅ beschreiben potentielle Kontakte einer Werkzeuggrundplatte des Werkzeugs 15 bzw. des Antriebs 23 mit einem Menschen. Da auch diese Roboterglieder als Zylinderprimitiv modelliert sind, sind auch diese Kontakte POI₃ und POI₅ durch eine Auswärtsnormale angedeutet, die potentielle Kontaktgeschwindigkeiten und -punkte beschreiben. Weiter können Parameter dieser Kontakte ebenfalls beispielsweise ihre reflektierte Trägheit, ihre Kontaktsteifigkeit und/oder -dämpfung, ihre Oberflächen- bzw. Kontakthärte und/oder -rauhigkeit und dergleichen beschreiben.

Die umgebungsfesten Kontakte POI₇ und POI₈ beschreiben potentielle Kontakte eines Tisches 30 mit einem Menschen und sind in Fig. 1 aufgrund der analogen Kontaktgeometrie in gleicher Weise wie die POI₁ und POI₂ durch Koordinatensysteme angedeutet, die potentielle Kontaktgeschwindigkeiten und -punkte beschreiben. Weiter können Parameter dieser Kontakte ebenfalls beispielsweise ihre reflektierte Trägheit, ihre Kontaktsteifigkeit und/oder -dämpfung, ihre Oberflächen- bzw. Kontakthärte und/oder -rauhigkeit und dergleichen beschreiben.

Die Kontakte werden dann in einem Schritt S20 wahlweise oder, teilweise oder vollständig, automatisiert verschiedenen Gruppen C₁ bis C₃ zugeordnet, die in Fig. 1 strichliert angedeutet sind.

Dabei repräsentiert die Gruppe C₁ potentielle Kontakte des Greifers 15. Entsprechend werden dieser Gruppe C₁ in Abhängigkeit von ihrer festen Position relativ zu dem Greifer 15 die Kontakte POI₁ bis POI₃ zugeordnet.

Die Gruppe C₂ repräsentiert potentielle Kontakte, deren Position und Geschwindigkeit nur von den Gelenkkoordinaten der Gelenke bzw. Antriebe 21 bis 23 abhängt. Entsprechend werden dieser Gruppe C₂ in Abhängigkeit von den ihre Kinematik bestimmenden Gelenken die Kontakte POI₄ bis POI₆ zugeordnet.

Die Gruppe C₃ repräsentiert umgebungsfeste potentielle Kontakte, deren Position und Geschwindigkeit nicht von den Gelenkkoordinaten der Gelenke bzw. Antriebe 21 bis 23 abhängt. Entsprechend werden dieser Gruppe C₃ die Kontakte POI₇ und POI₈ zugeordnet.

Für diese Kontakte POI₇ und POI₈ wird in einem Schritt S30 jeweils vorab oder im Betrieb des Roboters 10 eine kontaktspezifische Größe x₁ bis x₈ in Abhängigkeit von einem potentiellen medizinischen Schaden eines Menschen durch den jeweiligen Kontakt ermittelt.

Die kontaktspezifische Größe kann beispielsweise eine Geschwindigkeit oder reflektierte Trägheit in diesem Kontakt angeben, die in Hinblick auf einen potentiellen medizinischen Schaden eines Menschen durch diesen Kontakt maximal zulässig ist. Gleichermaßen kann die kontaktspezifische Größe zum Beispiel einen potentiellen medizinischen Schaden eines Menschen durch diesen Kontakt angeben.

Dann werden in einem Schritt S40 für diese Gruppen C₁ bis C₃ jeweils drei gruppenspezifische Größen (y₁₁, y₁₂, y₁₃), (y₂₁, y₂₂, y₂₃) bzw. (y₃₁, y₃₂, y₃₃) auf Basis der kontaktspezifischen Größen von dieser Gruppe zugeordneten Kontakte x₁ bis x₈ ermittelt.

Dabei wird als gruppenspezifische Größe y₁₁ die maximale oder minimale der kontaktspezifischen Größen x₁ bis x₃ ermittelt, beispielsweise das Maximum der potentiellen Schäden x₁ bis x₃ oder das Minimum der maximal zulässigen Geschwindigkeiten x₁ bis x₃. Analog wird als gruppenspezifische Größe y₂₁ die maximale oder minimale der kontaktspezifischen Größen x₄ bis x₆ ermittelt, beispielsweise das Maximum der potentiellen Schäden x₄ bis x₆ oder das Minimum der maximal zulässigen Geschwindigkeiten x₄ bis x₆. Als gruppenspezifische Größe y₃₁ wird analog die maximale oder minimale der kontaktspezifischen Größen x₇, x₈ ermittelt, beispielsweise das Maximum der potentiellen Schäden x₇, x₈ oder das Minimum der maximal zulässigen Geschwindigkeiten x₇, x₈. Diese gruppenspezifischen Größen y₁₁, y₂₁ und y₃₁ werden somit auf Basis eines Vergleichs der jeweiligen kontaktspezifischen Größen (x₁, x₂, x₃), (x₄, x₅, x₆) bzw. (x₇, x₈) miteinander innerhalb der Gruppe C₁, C₂ bzw. C₃ ermittelt.

Als gruppenspezifische Größe y₁₂ wird die Anzahl der kontaktspezifischen Größen x₁ bis x₃ ermittelt, die einen vorgegebenen Grenzwert über- oder unterschreiten, beispielsweise einen oberen Grenzwert für einen potentiellen Schaden überschreiten oder einen unteren Grenzwert für eine maximal zulässige Geschwindigkeit unterschreiten. Analog wird als gruppenspezifische Größe y₂₂ die Anzahl der kontaktspezifischen Größen x₄ bis x₆ ermittelt, die diesen Grenzwert über- bzw. unterschreiten. Als gruppenspezifische Größe y₃₂ wird analog die Anzahl der kontaktspezifischen Größen x₇, x₈ ermittelt, die diesen Grenzwert über- bzw. unterschreiten. Diese gruppenspezifischen Größen y₁₂, y₂₂ und y₃₂ werden somit auf Basis eines Vergleichs der jeweiligen kontaktspezifischen Größen (x₁, x₂, x₃), (x₄, x₅, x₆) bzw. (x₇, x₈) mit einem vorgegebenen Grenzwert innerhalb der Gruppe C₁, C₂ bzw. C₃ ermittelt.

Als gruppenspezifische Größe y₁₃ wird der Mittelwert der kontaktspezifischen Größen x₁ bis x₃ ermittelt. Analog wird als gruppenspezifische Größe y₂₃ der Mittelwert der kontaktspezifischen Größen x₄ bis x₆ ermittelt, als gruppenspezifische Größe y₃₂ der Mittelwert der kontaktspezifischen Größen x₇, x₈. Diese gruppenspezifischen Größen y₁₃, y₂₃ und y₃₃ werden somit auf Basis einer Mittelung von kontaktspezifischen Größen innerhalb der Gruppe C₁, C₂ bzw. C₃ ermittelt.

Dann werden im Schritt S40 die gruppenspezifischen Größen (y₁₁, y₂₁ und y₃₁) miteinander verglichen, ebenso die gruppenspezifischen Größen (y₁₂, y₂₂ und y₃₂) miteinander sowie die gruppenspezifischen Größen (y₁₃, y₂₃ und y₃₃) miteinander. Zusätzlich oder alternativ können die gruppenspezifischen Größen (y₁₁, y₂₁ und y₃₁), (y₁₂, y₂₂ und y₃₂) und/oder (y₁₃, y₂₃ und y₃₃) jeweils mit einem vorgegebenen Grenzwert verglichen werden.

Auf diese Weise kann identifiziert werden, welche der Gruppen C₁, C₂ bzw. C₃ beispielsweise das höchste maximale oder mittlere Gefährdungspotential aufweist oder die maximal zulässige Geschwindigkeit am stärksten oder gewichtigsten, d.h. mit aufgrund vieler potentieller Kontakte, limitiert. Dann können gezielt diese Gruppen optimiert werden. Insbesondere kann hierzu eine Information ausgegeben werden, welche anzeigt, dass diese Gruppen optimiert bzw. betrachtet werden sollen oder müssen.

Ergibt beispielsweise der Vergleich der gruppenspezifischen Größen, dass die Gruppe C₁ das höchste maximale oder mittlere Gefährdungspotential aufweist oder die maximal zulässige Geschwindigkeit am stärksten oder gewichtigsten limitiert, kann gezielt ein anderer Greifer gewählt oder der Greifer optimiert werden. Ergibt der Vergleich der gruppenspezifischen Größen, dass beispielsweise die Gruppe C₂ das höchste maximale oder mittlere Gefährdungspotential aufweist oder die maximal zulässige Geschwindigkeit am stärksten oder gewichtigsten limitiert, kann gezielt eine Bewegung in den Gelenken 21 bis 23 optimiert werden. Insbesondere kann hierzu eine Information ausgegeben werden, welche anzeigt, dass diese Gelenke 21 bis 23 optimiert bzw. betrachtet werden sollen oder müssen. Ergibt der Vergleich der gruppenspezifischen Größen, dass beispielsweise die Gruppe C₃ das höchste maximale oder mittlere Gefährdungspotential aufweist oder die maximal zulässige Geschwindigkeit am stärksten oder gewichtigsten limitiert, kann der Tisch 30 ausgetauscht oder umgestellt werden.

Obwohl in der vorhergehenden Beschreibung exemplarische Ausführungen erläutert wurden, sei darauf hingewiesen, dass eine Vielzahl von Abwandlungen möglich ist. So wurden im Ausführungsbeispiel insbesondere bereits die kontaktspezifischen Größen auf Basis einer Risikobewertung ermittelt. Gleichermaßen können in einer Abwandlung, wie einleitend erläutert, zunächst kontaktspezifische Größen ermittelt werden, die einen potentiellen medizinischen Schaden eines Menschen durch den jeweiligen Kontakt bestimmen, jedoch noch ohne eine Risikobewertung, beispielsweise die Kontaktgeschwindigkeiten oder Trägheiten. Dann können die gruppenspezifischen Größen in Abhängigkeit von einem potentiellen medizinischen Schaden eines Menschen durch die Kontakte der jeweiligen Gruppe ermittelt werden, beispielsweise die Kontaktgeschwindigkeiten, die eine zur Vermeidung einer unzulässigen Verletzung des Menschen maximal zulässige Geschwindigkeit übersteigen. Außerdem sei darauf hingewiesen, dass es sich bei den exemplarischen Ausführungen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere in Hinblick auf die Funktion und Anordnung der beschriebenen Bestandteile, vorgenommen werden können, ohne den Schutzbereich zu verlassen.

### Bezugszeichenliste

- 10: Roboter
- 11: Basis
- 12: Karussell
- 13: Arm
- 14: Hand
- 15: Greifer (Werkzeug)
- 21-24: Gelenk(antrieb)
- 30: Tisch
- 40: Steuerung
- POI1 - POI₈: potentieller Kontakt
- C₁ - C₃: Gruppe
- x₁ - x₈: kontaktspezifische Größe
- y₁₁ - y₃₃: gruppenspezifische Größe

## Patentansprüche

1. Verfahren zum Auslegen und/oder Betreiben eines Roboters (10), wobei mehrere potentielle Kontakte (POI₁ - POI₈) eines Menschen mit dem Roboter und/oder einer Umgebung bestimmt (S10) und für diese Kontakte jeweils eine kontaktspezifische Größe (x₁ - x₈) ermittelt wird (S30);
die Kontakte verschiedenen Gruppen (C₁ - C₈) zugeordnet werden (S20); und für, insbesondere ausgewählte, Gruppen jeweils wenigstens eine gruppenspezifische Größe (y₁₁ - y₃₃) auf Basis von kontaktspezifischen Größen von dieser Gruppe zugeordneten Kontakte ermittelt wird (S40);
wobei die kontaktspezifischen Größen und/oder die wenigstens eine gruppenspezifische Größe in Abhängigkeit von einem potentiellen medizinischen Schaden eines Menschen ermittelt wird und wenigstens einer Gruppe wenigstens zwei Kontakte zugeordnet werden,
**dadurch gekennzeichnet, dass**
wenigstens eine gruppenspezifische Größe eine zur Vermeidung unzulässiger medizinischer Schäden zulässige reflektierte Trägheit angibt oder eine maximal zulässige reflektierte Trägheit zur Vermeidung unzulässiger medizinischer Schäden umfasst.

2. Verfahren nach dem vorhergehenden Anspruch, **dadurch gekennzeichnet, dass** eine gruppenspezifische Größe (y₁₁ , y₂₁, y₃₁) auf Basis eines Vergleichs von kontaktspezifischen Größen miteinander innerhalb der Gruppe ermittelt wird.

3. Verfahren nach einem der vorhergehenden Ansprüche, **dadurch gekennzeichnet, dass** eine gruppenspezifische Größe (y₁₂ , y₂₂, y₃₂) auf Basis eines Vergleichs von kontaktspezifischen Größen mit wenigstens einem vorgegebenen Grenzwert innerhalb der Gruppe ermittelt wird.

4. Verfahren nach einem der vorhergehenden Ansprüche, **dadurch gekennzeichnet, dass** eine gruppenspezifische Größe (y₁₃ , y₂₃, y₃₃) auf Basis einer Mittelung von kontaktspezifischen Größen innerhalb der Gruppe ermittelt wird.

5. Verfahren nach einem der vorhergehenden Ansprüche, **dadurch gekennzeichnet, dass** gruppenspezifische Größen miteinander und/oder wenigstens einem vorgegebenen Grenzwert verglichen werden (S40).

6. Verfahren nach einem der vorhergehenden Ansprüche, **dadurch gekennzeichnet, dass** Kontakte Gruppen in Abhängigkeit von ihrer Position relativ zu Strukturelementen, insbesondere Bauteilen oder Bauteilgruppen, des Roboters und/oder den ihre Kinematik bestimmenden Gelenkkoordinaten des Roboters zugeordnet werden.

7. Verfahren nach einem der vorhergehenden Ansprüche, **dadurch gekennzeichnet, dass** Kontakte Gruppen wahlweise zugeordnet werden können.

8. Verfahren nach einem der vorhergehenden Ansprüche, **dadurch gekennzeichnet, dass** eine gruppen- und/oder kontaktspezifische Größe (x₁ - x₈) einen potentiellen medizinischen Schaden eines Menschen angibt.

9. Verfahren nach einem der vorhergehenden Ansprüche, **dadurch gekennzeichnet, dass** eine gruppen- und/oder kontaktspezifische Größe (x₁ - x₈) eine, insbesondere zulässige, kinematische Größe, insbesondere Geometrie, Position, Geschwindigkeit und/oder Beschleunigung, und/oder eine, insbesondere zulässige, dynamische Größe, insbesondere Steifigkeit, Dämpfung und/oder Trägheit, angibt.

10. Verfahren nach einem der vorhergehenden Ansprüche, **dadurch gekennzeichnet, dass** eine Kontaktgeometrie, eine kinematische Kontaktgröße, insbesondere eine Position, Orientierung und/oder Geschwindigkeit, und/oder eine dynamische Kontaktgröße, insbesondere eine Kontaktsteifigkeit, -dämpfung und/oder Trägheit für einen Kontakt ermittelt wird, wenn dieser bestimmt wird.

11. Verfahren nach einem der vorhergehenden Ansprüche, **dadurch gekennzeichnet, dass** das Verfahren, automatisiert während des Betriebs des Roboters und/oder vorab durchgeführt wird, wobei die Bestimmung von mehreren potentiellen Kontakten (POI1- POI3) (S10) und die Zuordnung der Kontakte in verschiedenen Gruppen (C1- C3) (S20) wenigstens teilweise automatisiert durchgeführt werden können.

12. Verfahren nach einem der vorhergehenden Ansprüche, **dadurch gekennzeichnet, dass** wenigstens einer der Kontakte roboter- oder umgebungsfest ist.

13. Mittel (40) zum Auslegen und/oder Betreiben eines Roboters, **dadurch gekennzeichnet, dass** es zum automatisierten Durchführen eines Verfahrens nach einem der vorhergehenden Ansprüche eingerichtet ist, wobei das Mittel eingerichtet ist, die Bestimmung von mehreren potentiellen Kontakten (POI1- POI3) (S10) und die Zuordnung der Kontakte in verschiedenen Gruppen (C1- C3) (S20) wenigstens teilweise automatisiert durchzuführen.

14. Computerprogrammprodukt mit einem Programmcode, der auf einem von einem Computer lesbaren Medium gespeichert ist, umfassend Befehle, die bewirken, dass die Mittel des Anspruchs 13 die Verfahrensschritte nach einem der Ansprüche 1 bis 12 ausführen.

## Claims

1. A method of designing and / or operating a robot (10), wherein a plurality of potential contacts (POI₁ - POI₈) of a person with the robot and / or an environment are determined (S10) and a contact-specific quantity (x₁ - x₈) is determined (S30) for each of these contacts;
the contacts are assigned (S20) to different groups (C₁ - C₈); and
for groups, in particular for selected groups, on an individual basis, at least one group-specific quantity (y₁₁ - y₃₃) is determined on the basis of contact-specific quantities of contacts which are assigned to this group (S40);
wherein the contact-specific quantities and / or the at least one group-specific quantity is determined as a function of a potential medical harm to a person, and at least two contacts are assigned to at least one group,
**characterised in that**
at least one group-specific quantity indicates a permissible reflected inertia for avoiding impermissible medical harm, or comprises a maximum permissible reflected inertia for avoiding impermissible medical harm.

2. The method according to the preceding claim, **characterised in that** a group-specific quantity (y₁₁ , y₂₁, y₃₁) is determined on the basis of a comparison of contact-specific quantities with each other within the group.

3. The method according to any one of the preceding claims, **characterised in that** a group-specific quantity (y₁₂, y₂₂, y₃₂) is determined on the basis of a comparison of contact-specific quantities with at least one predetermined threshold value within the group.

4. The method according to any one of the preceding claims, **characterised in that** a group-specific quantity (y₁₃, y₂₃, y₃₃) is determined on the basis of an averaging of contact-specific quantities within the group.

5. The method according to any one of the preceding claims, **characterised in that** group-specific quantities are compared with each other and / or with at least one predetermined threshold value (S40).

6. The method according to any one of the preceding claims, **characterised in that** contacts are assigned to groups as a function of their position relative to structural elements, in particular components or component groups, of the robot and / or the joint coordinates of the robot determining their kinematics.

7. The method according to any one of the preceding claims, **characterised in that** contacts can be selectively assigned to groups.

8. The method according to any one of the preceding claims, **characterised in that** a group-specific and / or contact-specific quantity (x₁ - x₈) indicates a potential medical harm of a person.

9. The method according to any one of the preceding claims, **characterised in that** a group-specific and / or a contact-specific quantity (x₁ - x₈) indicates a kinematic quantity, in particular a geometry, a position, a velocity and / or an acceleration, in particular a permissible kinematic quantity, in particular a permissible geometry, a permissible position, a permissible velocity and / or a permissible acceleration, and / or a dynamic quantity, in particular a stiffness, a quantity of damping and / or an inertia, in particular a permissible dynamic quantity, in particular a permissible stiffness, a permissible quantity of damping and / or a permissible inertia.

10. The method according to any one of the preceding claims, **characterised in that** a contact geometry, a kinematic contact quantity, in particular a position, an orientation and / or a velocity, and / or a dynamic contact quantity, in particular a contact stiffness, contact damping and / or contact inertia, is determined for a contact when the contact is being determined.

11. The method according to any one of the preceding claims, **characterised in that** the method is carried out in an automated manner during operation of the robot and / or in advance, wherein the determination of a plurality of potential contacts (POI1 - POI3) (S10) and the assigning of the contacts to different groups (C1 - C3) (S20) can be carried out in an at least partially automated manner.

12. The method according to any one of the preceding claims, **characterised in that** at least one of the contacts is fixed with respect to the robot or with respect to the environment.

13. A means (40) for designing and / or operating a robot, **characterised in that** the means is arranged to carry out a method according to any one of the preceding claims in an automated manner, wherein the means is arranged to carry out the determination of a plurality of potential contacts (POI1 - POI3) (S10) and the assigning of the contacts to different groups (C1 - C3) (S20) in an at least partially automated manner.

14. A computer program product comprising a program code which is stored on a computer readable medium, wherein the program code comprises instructions which cause the means of claim 13 to carry out the method steps according to any one of the claims 1 to 12.

## Revendications

1. Procédé de conception et/ou de fonctionnement d'un robot (10), dans lequel plusieurs contacts potentiels (POI₁ - POI₈) d'une personne avec le robot et/ou un environnement sont déterminés (S10) et respectivement une grandeur spécifique au contact (x₁ - x₈) est identifiée pour ces contacts (S30) ;
les contacts sont associés à différents groupes (C₁ - C₈) (S20) ; et
pour des groupes, en particulier sélectionnés, respectivement au moins une grandeur spécifique au groupe (y₁₁ - y₃₃) est identifiée sur la base de grandeurs spécifiques au contact de contacts associés à ce groupe (S40) ;
dans lequel les grandeurs spécifiques au contact et/ou l'au moins une grandeur spécifique au groupe est identifiée en fonction d'un dommage médical potentiel d'une personne et au moins deux contacts sont associés à au moins un groupe,
**caractérisé en ce que**
au moins une grandeur spécifique au groupe indique une inertie réfléchie admissible pour éviter des dommages médicaux inadmissibles ou comprend une inertie réfléchie admissible maximum pour éviter des dommages médicaux inadmissibles.

2. Procédé selon la revendication précédente, **caractérisé en ce qu'**une grandeur spécifique au groupe (y₁₁, y₂₁, y₃₁) est identifiée sur la base d'une comparaison de grandeurs spécifiques au contact les unes avec les autres à l'intérieur du groupe.

3. Procédé selon l'une quelconque des revendications précédentes, **caractérisé en ce qu'**une grandeur spécifique au groupe (y₁₂, y₂₂, y₃₂) est identifiée sur la base d'une comparaison de grandeurs spécifiques au contact avec au moins une valeur limite prédéfinie à l'intérieur du groupe.

4. Procédé selon l'une quelconque des revendications précédentes, **caractérisé en ce qu'**une grandeur spécifique au groupe (y₁₃, y₂₃, y₃₃) est identifiée sur la base d'une moyenne de grandeurs spécifiques au contact à l'intérieur du groupe.

5. Procédé selon l'une quelconque des revendications précédentes, **caractérisé en ce que** des grandeurs spécifiques au groupe sont comparées les unes avec les autres et/ou avec au moins une valeur limite prédéfinie (S40).

6. Procédé selon l'une quelconque des revendications précédentes, **caractérisé en ce que** des contacts sont associés à des groupes en fonction de leur position par rapport à des éléments structurels, en particulier composants ou groupes de composants, du robot et/ou des coordonnées d'articulation déterminant leur cinématique du robot.

7. Procédé selon l'une quelconque des revendications précédentes, **caractérisé en ce que** des contacts peuvent être associés au choix à des groupes.

8. Procédé selon l'une quelconque des revendications précédentes, **caractérisé en ce qu'**une grandeur spécifique au groupe et/ou au contact (x₁ - x₈) indique un dommage médical potentiel d'une personne.

9. Procédé selon l'une quelconque des revendications précédentes, **caractérisé en ce qu'**une grandeur spécifique au groupe et/ou au contact (x₁ - x₈) indique une grandeur cinématique, en particulier admissible, en particulier géométrie, position, vitesse et/ou accélération, et/ou une grandeur dynamique, en particulier admissible, en particulier rigidité, amortissement et/ou inertie.

10. Procédé selon l'une quelconque des revendications précédentes, **caractérisé en ce qu'**une géométrie de contact, une grandeur de contact cinématique, en particulier une position, orientation et/ou vitesse, et/une grandeur de contact dynamique, en particulier une rigidité de contact, amortissement de contact et/ou inertie est identifiée pour un contact, lorsque celui-ci est déterminé.

11. Procédé selon l'une quelconque des revendications précédentes, **caractérisé en ce que** le procédé est réalisé de manière automatisée pendant le fonctionnement du robot et/ou au préalable, dans lequel la détermination de plusieurs contacts potentiels (POI1 - POI3) (S10) et l'association des contacts dans différents groupes (C1 - C3) (S20) peuvent être réalisées de façon au moins partiellement automatisée.

12. Procédé selon l'une quelconque des revendications précédentes, **caractérisé en ce qu'**au moins un des contacts est solidaire au robot ou à l'environnement.

13. Moyen (40) de conception et/ou de fonctionnement d'un robot, **caractérisé en ce qu'**il est aménagé pour la réalisation automatisée d'un procédé selon l'une quelconque des revendications précédentes, dans lequel le moyen est aménagé pour réaliser de façon au moins partiellement automatisée la détermination de plusieurs contacts potentiels (POI1 - POI3) (S10) et l'association des contacts dans différents groupes (C1 - C3) (S20).

14. Produit de programme informatique avec un code de programme, qui est enregistré sur un support lisible par un ordinateur, comprenant des ordres, qui amènent les moyens de la revendication 13 à réaliser les étapes de procédé selon l'une quelconque des revendications 1 à 12.
